# EUROPEAN PATENT SPECIFICATION

(11) **EP 3 106 885 B1**
(45) Date of publication and mention of the grant of the patent: **28.02.2018**
(21) Application number: 16173497.5
(22) Date of filing: 08.06.2016
(51) Int. Cl.: G01R 19/175, H02M 1/42, G01R 19/165, H02M 1/08

(54) **ZERO CROSSING POINT DETECTING DEVICE, POWER SUPPLY DEVICE, AND ZERO CROSSING POINT DETECTING METHOD**
NULLDURCHGANGDETEKTIONSVORRICHTUNG, STROMVERSORGUNGSVORRICHTUNG, UND NULLDURCHGANGDETEKTIONSVERFAHREN
DISPOSITIF ET PROCÉDÉ DE DÉTECTION DE POINT DE PASSAGE PAR ZÉRO ET DISPOSITIF D'ALIMENTATION ÉLECTRIQUE

(30) Priority: 17.06.2015 JP 2015121699
(43) Date of publication of application: 21.12.2016
(73) Proprietor: MITSUBISHI HEAVY INDUSTRIES, LTD., Tokyo (JP)
(72) Inventor: SATO, Takeshi, Minato-Ku, Tokyo (JP); KUHARA, Masakazu, Minato-Ku, Tokyo (JP); AIBA, Kenichi, Minato-Ku, Tokyo (JP)
(74) Representative: Intès, Didier Gérard André

(56) References cited:
- EP-A1- 2 369 049
- JP-A- 2006 254 692
- US-A1- 2006 093 388

## Description

### BACKGROUND OF THE INVENTION

### Field of the Invention

The present invention relates to a zero crossing point detecting device, a power supply device, a zero crossing point detecting method, and a program.

### Description of Related Art

A power supply device that rectifies an alternating current (AC) voltage output from an AC power source to generate a direct current (DC) voltage and that drives a load with the generated DC voltage is known. Generally, a switching element is used in a circuit that generates the DC voltage from the AC voltage output from the AC power source in such a power supply device. The switching operation of the switching element is controlled by a control signal which is generated on the basis of a timing based on a zero crossing point of the AC voltage output from the AC power source.

Japanese Unexamined Patent Application, First Publication No. 2013-208018 (hereinafter, referred to as Patent Document 1), Japanese Patent No. 3708468 (hereinafter, referred to as Patent Document 2), Japanese Patent No. 5409152 (hereinafter, referred to as Patent Document 3), and Japanese Unexamined Patent Application, First Publication No. 2014-150622 (hereinafter, referred to as Patent Document 4) disclose relevant techniques. The devices disclosed in Patent Documents 1 to 4 detect a zero crossing point of an AC voltage output from an AC power source.

The impedance of an output terminal of an alternating current (AC) power source may be higher than the impedance of a load which is connected to the output terminal. The impedance of a wire which is connected to the output terminal of the AC power source may be higher than the impedance of the load. In these cases, a voltage waveform of an AC section in the power supply device may be disturbed by an influence of a switching operation of a switching element installed in the power supply device and it may be difficult to detect a crossing point, which is employed in the related art.

Accordingly, there is a demand for a technique capable of accurately specifying a zero crossing point even when the output of the AC power source is in a high-impedance state.

JP2006254692 (A) discloses a power supply device for detecting the abnormality of AC power supply and for stopping short-circuit operation.

US2006093388 (A1) refers to a power supply apparatus and heating apparatus and image forming apparatus.

EP2369049 (A1) describes a drum washing/drying machine including a rotating drum, a water tub, a drum motor, a rectifying circuit, a smoothing capacitor section, an inverter circuit, a short-circuit circuit that has a reactor and a short-circuit control element, and a control section.

### SUMMARY OF THE INVENTION

An object of the present invention is to provide a zero crossing point detecting device, a power supply device, a zero crossing point detecting method, and a program that can solve the above-mentioned problem.

According to a first aspect of the invention, there is provided a zero crossing point detecting device including: a crossing point detecting unit that detects a crossing of an alternating current voltage and a predetermined positive voltage, the predetermined positive voltage being output from an alternating current power source; and a control circuit that specifies a first detection timing, the first detection timing being a timing at which the crossing point detecting unit detects the crossing when the alternating current voltage is being increased, the control circuit specifying a second detection timing, the second detection timing being a timing at which the crossing point detecting unit detects the crossing during a predetermined detection period, the predetermined detection period being a period from an end time of a detection stop period to a detection period end time, the end time of the detection stop period being determined on the basis of the first detection timing, the end time of the detection stop period being earlier than when the voltage initially crosses the predetermined positive voltage after the first detection timing with the alternating current voltage being assumed to be an ideal alternating current voltage having a sinusoidal waveform of a single frequency, the detection period end time being earlier than when the voltage initially crosses zero volts after end of the detection stop period, the control circuit subtracting a difference between the first detection timing and the second detection timing from a half cycle of the alternating current voltage to obtain a value, the control circuit halving the obtained value to calculate a zero crossing point specifying parameter, the control circuit specifying a zero crossing time at which the alternating current voltage crosses zero volts on the basis of the zero crossing point specifying parameter and the cycle of the alternating current voltage, the control circuit controlling, on the basis of the specified zero crossing time, a switching operation of a switching element which is used to rectify the alternating current voltage into a direct current voltage.

According to a second aspect of the invention, in the above-described zero crossing point detecting device, the control circuit may add one cycle of the alternating current voltage to the first detection timing to decrease the zero crossing point specifying parameter, or add the half cycle of the alternating current voltage to the zero crossing point specifying parameter to specify the zero crossing time at the second detection timing.

According to a third aspect of the invention, in the above-described zero crossing point detecting device, the control circuit may repeatedly perform a process of setting one of a timing which is obtained by adding the half cycle of the alternating current voltage and double the zero crossing point specifying parameter to the second detection timing, a timing which is obtained by adding one cycle of the alternating current voltage to the first detection timing, and a timing at which the crossing point detecting unit first detects the crossing when the alternating current voltage is changed from a low voltage side to a high voltage side after the specified zero crossing time as a new first detection timing which is used to specify the zero crossing time of a next cycle, specifying a new second detection timing in the next cycle using the specified new first detection timing, calculating a new zero crossing point specifying parameter in the next cycle on the basis of the new first detection timing in the next cycle and the new second detection timing in the next cycle, specifying a new zero crossing time in the next cycle on the basis of the new zero crossing point specifying parameter in the next cycle and the cycle of the alternating current voltage, and controlling the switching operation of the switching element on the basis of the specified new zero crossing time in the next cycle.

According to a fourth aspect of the invention, there is provided a power supply device including: a rectifier circuit that converts alternating current power output from an alternating current power source into direct current power and supplies the direct current power to a load; a reactor that is connected in series between an output of the alternating current power source and the rectifier circuit; a switching element that is connected in parallel to a path of an alternating current voltage which is applied to the rectifier circuit via the reactor and performs a switching operation; a smoothing circuit that is connected in parallel to the rectifier circuit; a crossing point detecting unit that detects a crossing of an alternating current voltage and a predetermined positive voltage, the predetermined positive voltage being output from an alternating current power source; and a control circuit that specifies a first detection timing, the first detection timing being a timing at which the crossing point detecting unit detects the crossing when the alternating current voltage is being increased, the control circuit specifying a second detection timing, the second detection timing being a timing at which the crossing point detecting unit detects the crossing during a predetermined detection period, the predetermined detection period being a period from an end time of a detection stop period to a detection period end time, the end time of the detection stop period being determined on the basis of the first detection timing, the end time of the detection stop period being earlier than when the voltage initially crosses the predetermined positive voltage after the first detection timing with the alternating current voltage being assumed to be an ideal alternating current voltage having a sinusoidal waveform of a single frequency, the detection period end time being earlier than when the voltage initially crosses zero volts after end of the detection stop period, the control circuit subtracting a difference between the first detection timing and the second detection timing from a half cycle of the alternating current voltage to obtain a value, the control circuit halving the obtained value to calculate a zero crossing point specifying parameter, the control circuit specifying a zero crossing time at which the alternating current voltage crosses zero volts on the basis of the zero crossing point specifying parameter and the cycle of the alternating current voltage, the control circuit controlling, on the basis of the specified zero crossing time, a switching operation of a switching element which is used to rectify the alternating current voltage into a direct current voltage.

According to a fifth aspect of the invention, there is provided a zero crossing point detecting method including: detecting a crossing of an alternating current voltage and a predetermined positive voltage, the predetermined positive voltage being output from an alternating current power source; and specifying a first detection timing, the first detection timing being a timing at which a crossing point detecting unit detects the crossing when the alternating current voltage is being increased, specifying a second detection timing, the second detection timing being a timing at which the crossing point detecting unit detects the crossing during a predetermined detection period, the predetermined detection period being a period from an end time of a detection stop period to a detection period end time, the end time of the detection stop period being determined on the basis of the first detection timing, the end time of the detection stop period being earlier than when the voltage initially crosses the predetermined positive voltage after the first detection timing with the alternating current voltage being assumed to be an ideal alternating current voltage having a sinusoidal waveform of a single frequency, the detection period end time being earlier than when the voltage initially crosses zero volts after end of the detection stop period, subtracting a difference between the first detection timing and the second detection timing from a half cycle of the alternating current voltage to obtain a value, halving the obtained value to calculate a zero crossing point specifying parameter, specifying a zero crossing time at which the alternating current voltage crosses zero volts on the basis of the zero crossing point specifying parameter and the cycle of the alternating current voltage, and controlling, on the basis of the specified zero crossing time, a switching operation of a switching element which is used to rectify the alternating current voltage into a direct current voltage.

According to a sixth aspect of the invention, a program causes a computer to execute: detecting a crossing of an alternating current voltage and a predetermined positive voltage, the predetermined positive voltage being output from an alternating current power source; and detecting a crossing of an alternating current voltage output from an alternating current power source and a predetermined positive voltage; and specifying a first detection timing, the first detection timing being a timing at which a crossing point detecting unit detects the crossing when the alternating current voltage is being increased, specifying a second detection timing, the second detection timing being a timing at which the crossing point detecting unit detects the crossing during a predetermined detection period, the predetermined detection period being a period from an end time of a detection stop period to a detection period end time, the end time of the detection stop period being determined on the basis of the first detection timing, the end time of the detection stop period being earlier than when the voltage initially crosses the predetermined positive voltage after the first detection timing with the alternating current voltage being assumed to be an ideal alternating current voltage having a sinusoidal waveform of a single frequency, the detection period end time being earlier than when the voltage initially crosses zero volts after end of the detection stop period, subtracting a difference between the first detection timing and the second detection timing from a half cycle of the alternating current voltage to obtain a value, halving the obtained value to calculate a zero crossing point specifying parameter, specifying a zero crossing time at which the alternating current voltage crosses zero volts on the basis of the zero crossing point specifying parameter and the cycle of the alternating current voltage, and controlling, on the basis of the specified zero crossing time, a switching operation of a switching element which is used to rectify the alternating current voltage into a direct current voltage.

According to the zero crossing point detecting device, the power supply device, the zero crossing point detecting method, and the program which are described above, it is possible to accurately specify a zero crossing point even when an output of an alternating current power source is in a high-impedance state.

### BRIEF DESCRIPTION OF THE DRAWINGS

FIG. 1 is a diagram showing a configuration of a power supply device according to an embodiment of the present invention.
FIG. 2 is a diagram showing a configuration of a crossing point detecting unit according to an embodiment of the present invention.
FIG. 3 is a first diagram showing detecting of a crossing point in a crossing point detecting unit according to an embodiment of the present invention.
FIG. 4 is a second diagram showing detecting of a crossing point in a crossing point detecting unit according to an embodiment of the present invention.
FIG. 5 is a diagram showing detecting of a zero crossing point in a control circuit according to an embodiment of the present invention.
FIG. 6 is a diagram showing a process flow of a zero crossing point detecting device according to an embodiment of the present invention.

### EMBODIMENTS FOR CARRYING OUT THE INVENTION

### Embodiments

Hereinafter, embodiments of the present invention will be described in detail with reference to the accompanying drawings.

First, a configuration of a power supply device 10 according to an embodiment of the present invention will be described.

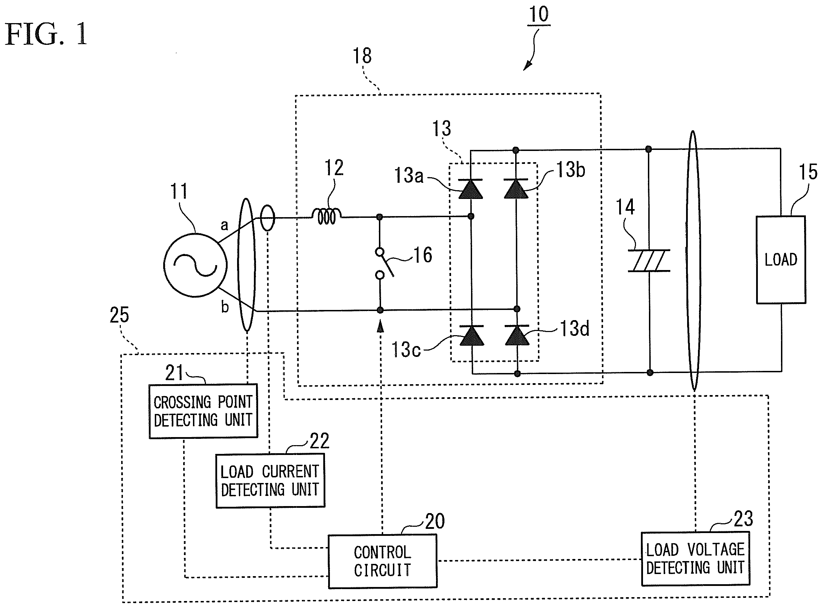

As shown in FIG. 1, the power supply device 10 according to the embodiment of the present invention includes an alternating current (AC) power source 11, a reactor 12, a rectifier circuit 13, a capacitor 14 (a smoothing circuit), a switching element 16, and a zero crossing point detecting device 25. In FIG. 1, a load 15 is shown along with the power supply device 10.

The rectifier circuit 13 includes four diodes 13a, 13b, 13c, and 13d. An anode of the diode 13a is connected to a cathode of the diode 13c. A cathode of the diode 13a is connected to a cathode of the diode 13b. An anode of the diode 13b is connected to a cathode of the diode 13d. An anode of the diode 13c is connected to an anode of the diode 13d. The rectifier circuit 13 converts AC power output from the AC power source 11 into direct current (DC) power and supplies the DC power to the load 15.

The AC power source 11 outputs AC power. Specifically, the AC power source 11 includes terminals "a" and "b". The AC power source 11 outputs an AC voltage from the terminal "a" with the voltage of the terminal "b" serving as a reference voltage.

The reactor 12 is connected in series between the output terminal of the AC power source 11 and the rectifier circuit 13. Specifically, the reactor 12 is connected in series between the terminal "a" of the AC power source 11 and the anode of the diode 13a.

The switching element 16 is connected in parallel in a path of an AC voltage which is applied to the rectifier circuit 13 via the reactor 12. Specifically, the switching element 16 is connected in series between the anode of the diode 13a and the terminal "b" of the AC power source 11. The switching element 16 performs a switching operation on the basis of control of a control circuit 20.

The reactor 12, the switching element 16, and the rectifier circuit 13 constitute a booster circuit 18. When the AC power source 11 outputs a current from the terminal "a", receives an input of a current from the terminal "b", and the switching element 16 is switched to a closed state, the reactor 12 is connected to the terminal "b" of the AC power source 11 and a current flowing from the terminal "a" to the reactor 12 increases. Here, when the switching element 16 is switched to an open state, energy accumulated in the reactor 12 is discharged, a current flows via the diode 13a, the capacitor 14, and the diode 13d, and electric charges are accumulated in the capacitor 14.

When the AC power source 11 outputs a current from the terminal "b" and receives an input of a current from the terminal "a", and the switching element 16 is in the closed state, the reactor 12 is connected to the terminal "b" of the AC power source 11 and a current flowing from the terminal "b" to the reactor 12 increases. Here, when the switching element 16 is switched to the open state, energy accumulated in the reactor 12 is discharged, a current flows via the diode 13b, the capacitor 14, and the diode 13c, and electric charges are accumulated in the capacitor 14. At this time, the capacitor 14 serves as a smoothing circuit.

The zero crossing point detecting device 25 includes the control circuit 20, a crossing point detecting unit 21, a load current detecting unit 22, and a load voltage detecting unit 23.

The crossing point detecting unit 21 detects a crossing of an AC voltage output from the AC power source 11 and a predetermined forward bias voltage (a predetermined positive voltage) for causing a photo diode of a photo-coupler 201 to emit light.

The load current detecting unit 22 detects a load current supplied to the load 15.

The load voltage detecting unit 23 detects a DC voltage supplied to the load 15.

The control circuit 20 specifies a first detection timing at which the crossing point detecting unit 21 first detects the crossing of the AC voltage and the predetermined forward bias voltage after the AC voltage output from the AC power source 11 increases from a voltage which is equal to or lower than zero volts. The control circuit 20 specifies a second detection timing at which the crossing point detecting unit 21 finally detects the crossing of the AC voltage and the predetermined forward bias voltage when the AC voltage output from the AC power source 11 decreases with the lapse of time. The second detection timing is specified in a predetermined detection period from a time before a first timing at which an ideal AC voltage with a sinusoidal waveform of a single frequency crosses the predetermined forward bias voltage after the first detection timing when the AC voltage output from the AC power source 11 is assumed to be the ideal AC voltage, the time being an end time of a detection stop period which is determined on the basis of the timing with the first detection timing as a reference, to a timing earlier than a first timing at which the ideal AC voltage crosses zero volts after the detection stop period ends. The control circuit 20 calculates a zero crossing point specifying parameter by halving a value which is obtained by subtracting a difference between the first detection timing and the second detection timing from a half cycle of the AC voltage using the first detection timing, the second detection timing, and a cycle of the AC voltage. The control circuit 20 specifies a zero crossing point (a zero crossing time) at which the AC voltage crosses zero volts on the basis of the zero crossing point specifying parameter and the cycle of the AC voltage. The control circuit 20 controls the switching operation of the switching element 16 on the basis of the specified zero crossing time. Specifically, the control circuit 20 generates a control signal for driving the switching element 16 in synchronization with the specified zero crossing point. The control circuit 20 intermits switching of the switching element 16 by transmitting the generated control signal to a drive circuit (not shown) of the switching element 16. This operation is embodied by causing the control circuit 20 to perform a predetermined operation on the basis of a program and a set value pre-stored in the control circuit 20.

One cycle of the AC voltage output from the AC power source 11 is set to a fixed value of an ideal cycle.

The control circuit 20 sets one of timings as a new first detection timing which is used to specify the zero crossing time of a next cycle. The timings are a timing which is obtained by adding the half cycle of the AC voltage output from the AC power source 11 and double the zero crossing point specifying parameter to the second detection timing, a timing which is obtained by adding one cycle of the AC voltage output from the AC power source 11 to the first detection timing, and a timing at which the crossing point detecting unit 21 first detects the crossing of the AC voltage and the predetermined forward bias voltage when the AC voltage output from the AC power source 11 increases with the lapse of time after the specified zero crossing time. The control circuit 20 specifies a new second detection timing in the next cycle using the new first detection timing. The control circuit 20 calculates a new zero crossing point specifying parameter in the next cycle on the basis of the new first detection timing in the next cycle and the new second detection timing in the next cycle. The control circuit 20 specifies a new zero crossing time in the next cycle on the basis of the calculated new zero crossing point specifying parameter in the next cycle and the cycle of the AC voltage output from the AC power source 11. The control circuit 20 repeatedly performs a process of controlling the switching operation of the switching element 16 on the basis of the specified new zero crossing time in the next cycle.

When the switching element 16 is an insulated gate bipolar transistor (IGBT), the control circuit 20 may control the timing at which the switching element 16 is switched to the open state by controlling a duration in which a voltage for turning on the IGBT is applied to the gate of the IGBT and a timing at which a voltage for turning off the IGBT is applied to the gate of the IGBT. The control circuit 20 may control the timing at which the switching element 16 is switched to the closed state by controlling the duration in which the voltage for turning off the IGBT is applied to the gate of the IGBT and the timing at which the voltage for turning on the IGBT is applied to the gate of the IGBT.

The switching element 16 is not limited to the IGBT. As long as impedance of the switching element 16 in the closed state is sufficiently smaller than impedance of a circuit connected in parallel to the switching element 16 and the switching element is switched to the open state and the closed state at an appropriate timing in response to the control signal from the control circuit 20, any element may be used.

The crossing point detecting unit 21 will be described below.

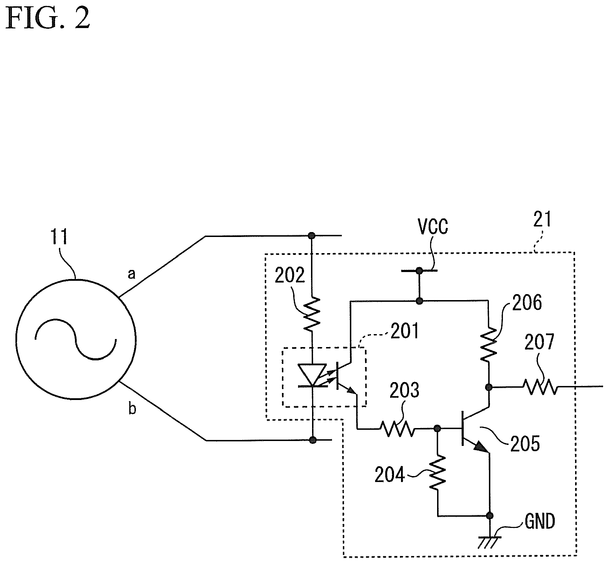

As shown in FIG. 2, the crossing point detecting unit 21 includes a photo-coupler 201, resistors 202, 203, 204, 206, and 207, and a bipolar transistor 205.

The AC power source 11 along with the crossing point detecting unit 21 is shown in FIG. 2.

The resistor 202 and the photo diode of the photo-coupler 201 are connected in series between the terminal "a" and the terminal "b" of the AC power source 11.

The collector of a current output transistor of the photo-coupler 201 is connected to a DC power source VCC.

The resistor 203 is connected in series between an emitter of the current output transistor of the photo-coupler 201 and a base of the bipolar transistor 205.

The resistor 204 is connected in parallel between the base and an emitter of the bipolar transistor 205. The emitter of the bipolar transistor 205 is connected to a ground GND.

The resistor 206 is connected in series between the DC power source VCC and a collector of the bipolar transistor 205.

The resistor 207 is connected in series between the collector of the bipolar transistor 205 and the control circuit 20 which is not shown.

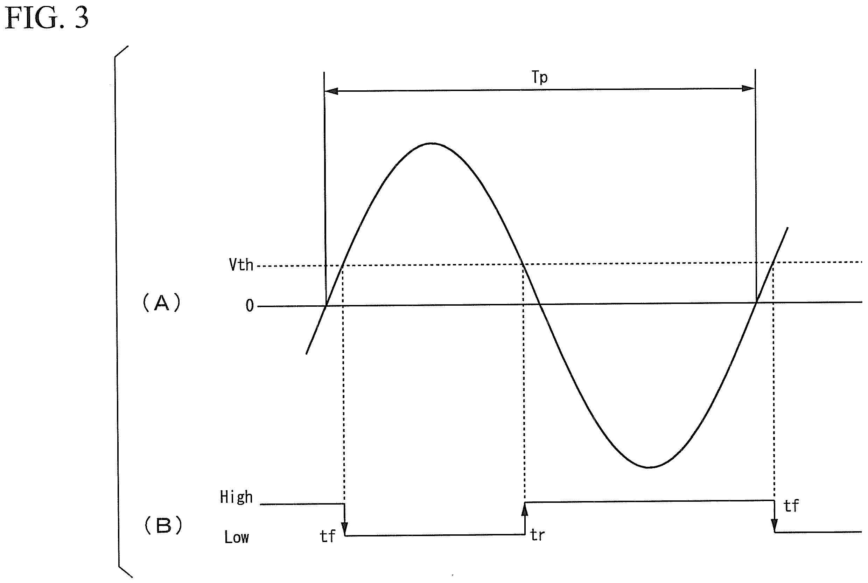

When the output voltage of the AC power source 11 is a voltage of a low level and a voltage lower than the predetermined bias voltage (for example, a voltage Vth shown in FIG. 3) is applied to the photo diode of the photo-coupler 201, the photo diode of the photo-coupler 201 does not sufficiently emit light and the current output transistor of the photo-coupler 201 is not irradiated with light. Accordingly, the current output transistor of the photo-coupler 201 does not allow a current to substantially flow. As a result, a current does not substantially flow in the resistor 204 and the base-emitter voltage of the bipolar transistor 205 is lower than an ON voltage (typically about 0.7 volts). The ON voltage shows the voltage at which a bipolar transistor operates in linear region. The bipolar transistor 205 is switched to an OFF state and the bipolar transistor 205 does not allow a current to flow. When the bipolar transistor 205 does not allow a current to flow, a current does not flow in the resistor 206 and the resistor 207 by setting the input impedance of the control circuit 20 to a high impedance and thus a voltage of a high level is input to the control circuit 20.

When the output voltage of the AC power source 11 is a voltage of a high level and a high voltage being equal to or higher than the predetermined forward bias voltage (for example, the voltage Vth shown in portion (A) of FIG. 3) is applied to the photo diode of the photo-coupler 201, the photo diode of the photo-coupler 201 sufficiently emits light and the current output transistor of the photo-coupler 201 is irradiated with light. Portion (A) of FIG. 3 shows the output voltage of the AC power source 11 and portion (B) of FIG. 3 shows the detection voltage of the crossing point detecting unit 21. When the current output transistor of the photo-coupler 201 is irradiated with light, the current output transistor causes a large current to flow from the collector to the emitter. When the current output transistor of the photo-coupler 201 causes a large current to flow from the collector to the emitter, the large current flows in the resistor 204 and the base-emitter voltage becomes equal to or higher than the ON voltage (typically about 0.7 volts). The bipolar transistor is changed to the ON state and bipolar transistor 205 causes a current to flow from the collector to the emitter. When the bipolar transistor 205 causes a current flow, the current flows in the resistor 206 to cause a voltage drop and the voltage at the collector of the bipolar transistor 205 becomes a low level. When input impedance of the control circuit 20 is set to a high impedance, a current does not flow in the resistor 207 and the voltage at the input of the control circuit 20 becomes a low level.

That is, the crossing point detecting unit 21 operates as an inverter circuit for logical inversion. Accordingly, when the voltage applied to the photo diode of the photo-coupler 201 is a voltage lower than the voltage Vth shown in portion (A) of FIG. 3, the crossing point detecting unit 21 outputs the voltage of a high level shown in portion (B) of FIG. 3. When the voltage applied to the photo diode of the photo-coupler 201 is a high voltage equal to or higher than the voltage Vth shown in portion (A) of FIG. 3, the crossing point detecting unit 21 outputs the voltage of a low level shown in portion (B) of FIG. 3.

The output voltage of the AC power source 11 when an output impedance of the AC power source 11 is a high impedance will be described below.

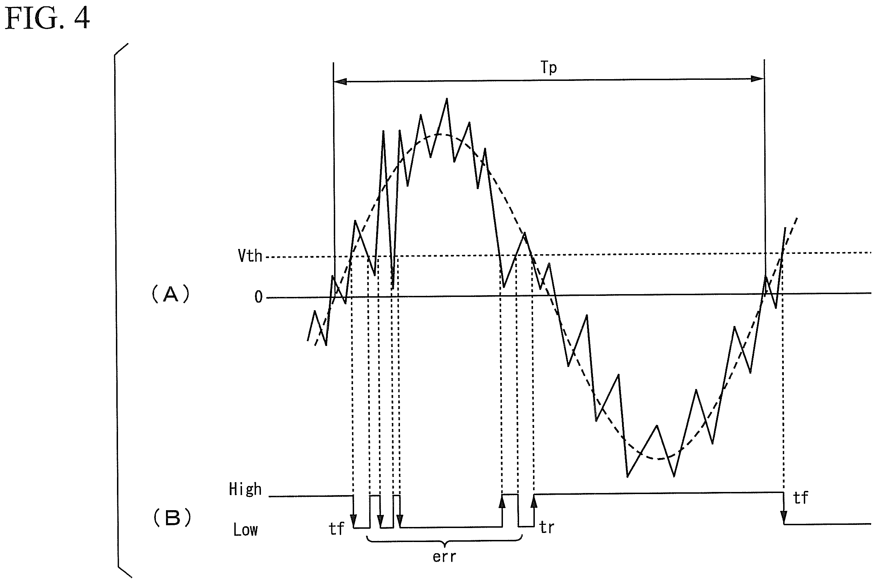

An influence of noise generated in the AC power source 11 on an output voltage fluctuation of the AC power source 11 or an influence of disturbance or the like on the output voltage fluctuation of the AC power source 11 increases for the following three reasons. The first reason is that the impedance of the terminal "a" of the AC power source 11 is higher than the impedance of a load connected to the terminal "a". The second reason is that the impedance of a wire from the terminal "a" of the AC power source 11 to the reactor 12 is high. The third reason is that the impedance in the switching operation of the switching element 16 unstably fluctuates at a high impedance until the impedance is stabilized to a low impedance. Due to the influence of the output voltage on the fluctuation, the AC voltage output from the AC power source 11 becomes a voltage at which noise is superimposed on a sinusoidal wave as shown in portion (A) of FIG. 4. The AC voltage output from the AC power source 11 crosses the voltage Vth four or more times (nine times in portion (A) of FIG. 4) in one cycle Tp of the voltage of a sinusoidal wave output from the AC power source 11.

When the AC voltage output from the AC power source 11 crosses the voltage Vth, the crossing point detecting unit 21 outputs a voltage rising from a voltage of a low level to a voltage of a high level or a detection voltage falling from the voltage of a high level to the voltage of a low level as shown in portion (B) of FIG. 4. Among the detection signals output from the crossing point detecting unit 21, the detection signal referenced by reference sign err in portion (B) of FIG. 4 is an undesirable detection signal err which is not output when the output voltage of the AC power source 11 is an ideal sinusoidal voltage.

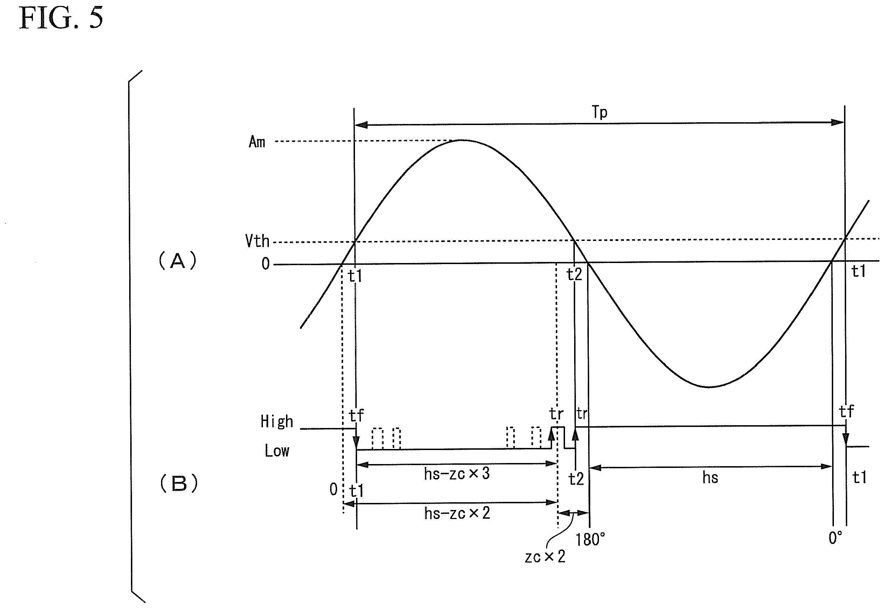

Therefore, the control circuit 20 according to the embodiment of the present invention specifies the first detection timing indicating a crossing point at which the AC voltage output from the AC power source 11 increases with the lapse of time and crosses the predetermined forward bias voltage for causing the photo diode of the photo-coupler 201 to emit light and which is first detected by the crossing point detecting unit 21. Specifically, with the output voltage of the AC power source 11 shown in portion (A) of FIG. 5, the crossing point detecting unit 21 outputs the detection voltage to the control circuit 20 when the output voltage of the AC power source 11 increases and first crosses the voltage Vth. The control circuit 20 specifies the timing at which the first detection voltage is input from the crossing point detecting unit 21 as a first detection timing t1.

The control circuit 20 specifies the second detection timing t2 at which the crossing point detecting unit 21 finally detects the crossing of the AC voltage and the predetermined forward bias voltage when the AC voltage output from the AC power source 11 decreases with the lapse of time. The second detection timing t2 is specified in the predetermined detection period from a time before the first timing (the timing indicated by reference sign "t2" in the example shown in FIG. 5) at which the ideal AC voltage with the sinusoidal waveform of the single frequency crosses the predetermined forward bias voltage after the first detection timing when the AC voltage output from the AC power source 11 is assumed to be the ideal AC voltage, the time being the end time (the time at which a time of hs-zcx3 elapses from the timing indicated by reference sign "t1" in the example shown in FIG. 5) of the detection stop period which is determined on the basis of the timing with the first detection timing as a reference, to the timing earlier than the first timing (the timing corresponding to reference sign "180°" in the example shown in FIG. 5) at which the ideal AC voltage crosses zero volts after the detection stop period ends. Specifically, the control circuit 20 calculates, for example, hs-zcx3 as the detection stop period. Reference sign "hs" is a half cycle (one cycle Tp/2) of the output voltage of the AC power source 11 and is a fixed value. Reference sign "zc" is a difference between the timing at which each of the zero crossing points is detected and the timing at which a crossing point at which the output voltage of the AC power source 11 crosses the voltage Vth is detected and which is closest to each of the zero crossing points, and is called a zero crossing point specifying parameter herein. A value calculated from the ideal sinusoidal wave of the AC power source 11 is used as an initial value of the zero crossing point specifying parameter zc. For example, when the amplitude of the output voltage of the AC power source 11 is defined as Am, the initial value of the zero crossing point specifying parameter zc can be calculated as zc=(hs/π)·sin⁻¹ (Vth/Am).

The predetermined detection stop period is a period in which the above-mentioned undesirable detection voltage err detected by the crossing point detecting unit 21 is ignored and is determined depending on the amplitude of the output voltage of the AC power source 11. When the AC voltage output from the AC power source 11 is changed from a high voltage side to a low voltage side and crosses the predetermined forward bias voltage for causing the photo diode of the photo-coupler 201 to emit light in a detection period (for example, a period after hs-zcx3 elapses from the first detection timing t1 and until zcx2 further elapses) after the predetermined detection stop period (for example, hs-zcx3) elapses from the first detection timing t1 and until the half cycle of the output voltage of the AC power source 11 elapses from the first detection timing t1, the crossing point detecting unit 21 outputs the detection voltage to the control circuit 20. The control circuit 20 specifies the last timing at which the detection voltage is input among the timings at which the detection voltage is input from the crossing point detecting unit 21 as the second detection timing t2.

The control circuit 20 calculates the zero crossing point specifying parameter which is half a value obtained by subtracting the difference between the first detection timing t1 and the second detection timing t2 from the half cycle of the AC voltage output from the AC power source 11 using the first detection timing t1, the second detection timing t2, and the half cycle of the AC voltage which were acquired in advance. The control circuit 20 specifies a zero crossing point by adding one cycle of the AC voltage output from the AC power source 11 to the first detection timing t1 and decreasing the zero crossing point specifying parameter. The control circuit 20 generates a control signal for driving the switching element 16 in synchronization with the specified zero crossing point.

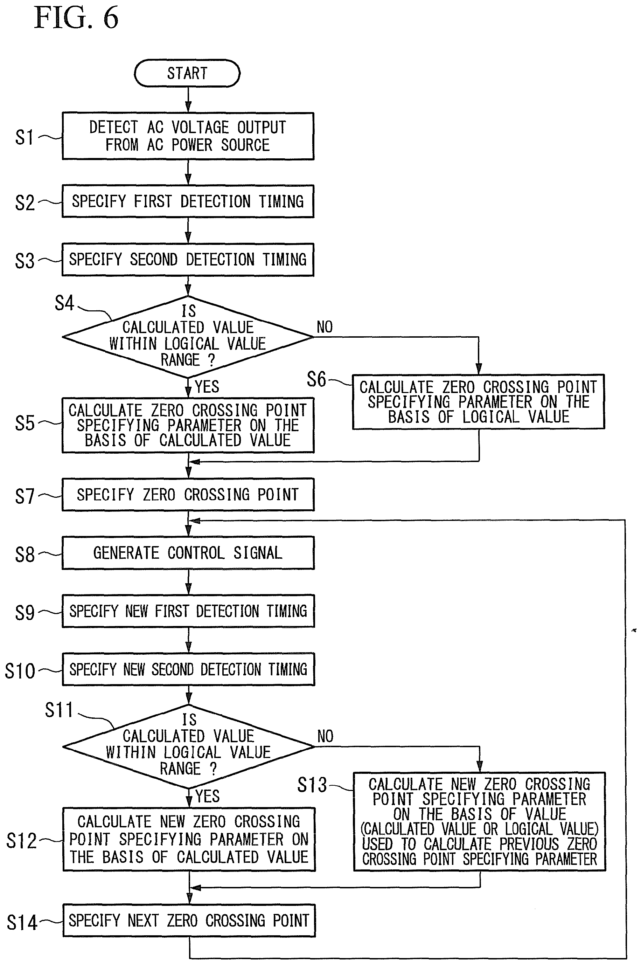

The process flow of the zero crossing point detecting device 25 according to the embodiment of the present invention shown in FIG. 6 will be described below.

It is assumed that the output impedance of the AC power source 11 is a high impedance and the crossing point detecting unit 21 outputs the undesirable detection signal err shown in FIG. 4. Since a timing at which the AC voltage becomes equal to or lower than zero volts is between the half cycle and the one cycle in each cycle of the AC voltage, the control circuit 20 can calculate the timing at which the AC voltage becomes equal to or lower than zero volts using a start timing of the AC power source 11 and the cycle of the AC voltage. It is assumed that the control circuit 20 acquires the start timing of the AC power source 11 and the cycle of the AC voltage in advance and calculates the timing at which the AC voltage becomes equal to or lower than zero volts in advance.

In an ON state, the AC power source 11 outputs an AC voltage at which noise is superimposed on a sinusoidal wave as shown in portion (A) of FIG. 4.

The crossing point detecting unit 21 detects an AC voltage output from the AC power source 11 (step S1) and outputs the detected voltage to the control circuit 20. Specifically, as shown in FIG. 2, the crossing point detecting unit 21 includes the photo-coupler 201, the resistors 202, 203, 204, 206, and 207, and the bipolar transistor 205. The crossing point detecting unit 21 operates as an inverter circuit for logical inversion. When a voltage applied to the photo diode of the photo-coupler 201 is a voltage lower than the voltage Vth shown in portion (A) of FIG. 3 after a timing at which the output voltage of the AC power source 11 increases from a voltage equal to or lower than zero volts, the crossing point detecting unit 21 outputs the voltage of a high level shown in portion (B) of FIG. 3 to the control circuit 20. When the voltage applied to the photo diode of the photo-coupler 201 is a voltage equal to or higher than the voltage Vth shown in portion (A) of FIG. 3, the crossing point detecting unit 21 outputs the voltage of a low level shown in portion (B) of FIG. 3 to the control circuit 20.

The control circuit 20 receives an input of the detected voltage from the crossing point detecting unit 21. The control circuit 20 specifies the timing at which a first detected voltage decreasing from the voltage of the high level input from the crossing point detecting unit 21 to the voltage of the low level is acquired after a timing at which the pre-calculated output voltage of the AC power source 11 increases from the voltage equal to or lower than zero volts as the first detection timing t1 (step S2). The first detection timing t1 is a timing of a crossing point which is first detected by the crossing point detecting unit 21 and at which the AC voltage output from the AC power source 11 increases with the lapse of time and crosses the predetermined forward bias voltage for causing the photo diode of the photo-coupler 201 to emit light.

The control circuit 20 specifies the second detection timing t2 which is finally detected in the predetermined detection period after the predetermined detection stop period elapses from the specified first detection timing t1 (step S3). The second detection timing t2 is a timing of a crossing point at which the AC voltage output from the AC power source 11 is changed from the high voltage side to the low voltage side and crosses the predetermined forward bias voltage for causing the photo diode of the photo-coupler 201 to emit light. Specifically, the control circuit 20 calculates, for example, hs-zcx3 as the predetermined detection stop period. A value which is calculated from an ideal sinusoidal wave of the AC power source 11 is used as the initial value of the zero crossing point specifying parameter zc. For example, when the amplitude of the AC power source 11 is defined as Am, the initial value of the zero crossing point specifying parameter zc can be calculated as zc=(hs/π)·sin⁻¹(Vth/Am). When the AC voltage output from the AC power source 11 is changed from the high voltage side to the low voltage side and crosses the predetermined forward bias voltage for causing the photo diode of the photo-coupler 201 to emit light in the detection period (for example, a period after hs-zcx3 elapses from the first detection timing t1 and until zcx2 further elapses) after the predetermined detection stop period (for example, hs-zcx3) elapses from the first detection timing t1 and until the half cycle of the output voltage of the AC power source 11 elapses from the first detection timing t1, the crossing point detecting unit 21 outputs the detection voltage to the control circuit 20. The control circuit 20 specifies the last timing at which the detection voltage is input among the timings at which the detection voltage is input from the crossing point detecting unit 21 as the second detection timing t2.

The control circuit 20 calculates the difference (t2-t1) between the first detection timing t1 and the second detection timing t2. The control circuit 20 determines whether the calculated difference (t2-t1) is within a range of theoretical values which are possible from the difference (t2-t1) (step S4).

When it is determined that the calculated difference (t2-t1) is within the range of theoretical values which are possible from the difference (t2-t1) (YES in step S4), the control circuit 20 calculates the zero crossing point specifying parameter zc by halving the value which is obtained by subtracting the calculated difference (t2-t1) from the half cycle hs of the AC voltage output from the AC power source 11 using the calculated difference (t2-t1) and the half cycle hs of the AC voltage which were acquired in advance (step S5).

When it is determined that the calculated difference (t2-t1) exceeds the range of theoretical values which are possible from the difference (t2-t1) (NO in step S4), the control circuit 20 calculates the zero crossing point specifying parameter zc by halving the value which is obtained by subtracting a theoretical value which is possible from the difference (t2-t1) from the half cycle hs of the AC voltage output from the AC power source 11 using the theoretical value which is possible from the difference (t2-t1) (for example, a median value of the theoretical values which are possible from the difference (t2-t1)) and the half cycle hs of the AC voltage which were acquired in advance (step S6).

The control circuit 20 specifies a zero crossing point on the basis of the zero crossing point specifying parameter zc and the cycle Tp of the AC voltage output from the AC power source 11 (step S7). For example, the control circuit 20 specifies the zero crossing point by adding one cycle Tp of the AC voltage output from the AC power source 11 to the first detection timing t1 and decreasing the zero crossing point specifying parameter zc. Alternatively, the control circuit 20 specifies the zero crossing point by adding the half cycle hs of the AC voltage and the zero crossing point specifying parameter to the second detection timing.

The control circuit 20 generates the control signal for driving the switching element 16 in synchronization with the specified zero crossing point (step S8).

The control circuit 20 specifies a new first detection timing which is used to specify a next zero crossing point (step S9). For example, the control circuit 20 specifies a timing which is obtained by adding a double value (2xzc) of the present zero crossing point specifying parameter zc and the half cycle hs of the AC voltage output from the AC power source 11 to the present first detection timing t1 as the new first detection timing. Alternatively, the control circuit 20 specifies a timing which is obtained by adding one cycle Tp of the AC voltage to the first detection timing as the new first detection timing. Alternatively, the control circuit 20 specifies a timing at which the crossing point detecting unit 21 first detects the crossing of the AC voltage and the predetermined forward bias voltage when the output voltage of the AC power source 11 is changed from the low voltage side to the high voltage side after the specified zero crossing time as the new first detection timing.

The control circuit 20 specifies a second detection timing at which the crossing point detecting unit 21 finally detects the crossing of the AC voltage and the predetermined forward bias voltage when the output voltage of the AC power source 11 is changed from the high voltage side to the low voltage side in the predetermined detection period after the predetermined detection stop period elapses from the specified new first detection timing t1 (step S10). For example, the control circuit 20 calculates the predetermined detection stop period hs-zcx3. The value of the zero crossing point specifying parameter zc which is calculated when the previous zero crossing point is specified from one cycle Tp of the AC voltage output from the AC power source 11 is used as the zero crossing point specifying parameter zc. The crossing point detecting unit 21 outputs the detected voltage to the control circuit 20 when the AC voltage output from the AC power source 11 is changed from the high voltage side to the low voltage side and crosses the predetermined forward bias voltage for causing the photo diode of the photo-coupler 201 to emit light in a detection period. The detection period starts when the predetermined detection stop period (for example, hs-zcx3) elapses from the new first detection timing t1, and lasts until when the half cycle hs of the output voltage of the AC power source 11 elapses from the new first detection timing t1. For example, the detection period starts when hs-zcx3 elapses from the first detection timing t1, and lasts when period until zcx2 further elapses. The control circuit 20 specifies the last timing at which the detected voltage is input among the timings at which the detected voltage is input from the crossing point detecting unit 21 as the new second detection timing t2.

The control circuit 20 calculates a difference (t2-t1) between the new first detection timing t1 and the new second detection timing t2. The control circuit 20 determines whether the calculated difference (t2-t1) is within the range of theoretical values which are possible from the difference (t2-t1) (step S11).

When it is determined that the calculated difference (t2-t1) is within the range of theoretical values which are possible from the difference (t2-t1) (YES in step S11), the control circuit 20 calculates a new zero crossing point specifying parameter zc which is half a value which is obtained by subtracting the calculated difference (t2-t1) from the half cycle hs of the AC voltage output from the AC power source 11 (step S12). The control circuit 20 calculates the new zero crossing point specifying parameter zc using the calculated difference (t2-t1) and the half cycle hs of the AC voltage which were acquired in advance.

When it is determined that the calculated difference (t2-t1) exceeds the range of theoretical values which are possible from the difference (t2-t1) (NO in step S11), the control circuit 20 calculates a new zero crossing point specifying parameter zc which is half a value obtained by subtracting the value of the difference, which was used to calculate the previous zero crossing point specifying parameter zc, from the half cycle hs of the AC voltage output from the AC power source 11 (step S13). The control circuit 20 calculates the new zero crossing point specifying parameter zc using the value of the difference (the difference (t2-t1) or the theoretical values which are possible from the difference (t2-t1)) which was used to calculate the previous zero crossing point specifying parameter zc and the half cycle hs of the AC voltage which were acquired in advance.

The control circuit 20 specifies a next zero crossing point on the basis of the new zero crossing point specifying parameter zc and the cycle Tp of the AC voltage output from the AC power source 11 (step S14). For example, the control circuit 20 specifies the zero crossing point by adding one cycle Tp of the AC voltage output from the AC power source 11 to the new first detection timing t1 and decreasing the zero crossing point specifying parameter zc. Alternatively, the control circuit 20 specifies the zero crossing point by adding the half cycle of the AC voltage and the zero crossing point specifying parameter zc to the second detection timing 2. The control circuit 20 returns the process flow to step S8.

The control circuit 20 specifies the zero crossing point by repeatedly performing the processes of steps S8 to S14, and generates the control signal for driving the switching element 16 in synchronization with the specified zero crossing point.

The process flow of the zero crossing point detecting device 25 according to the embodiment of the present invention has been described above. In the processes of the zero crossing point detecting device 25, the crossing point detecting unit 21 detects the crossing of the AC voltage output from the AC power source 11 and a predetermined voltage. The control circuit 20 specifies a first detection timing at which the crossing point detecting unit 21 first detects the crossing of the AC voltage and the predetermined voltage after the AC voltage output from the AC power source 11 increases from a voltage which is equal to or lower than zero volts. The control circuit 20 specifies a second detection timing at which the crossing point detecting unit 21 finally detects the crossing of the AC voltage and the predetermined forward bias voltage when the AC voltage output from the AC power source 11 decreases with the lapse of time. The second detection timing is specified in the predetermined detection period from a time before the first timing at which the ideal AC voltage with a sinusoidal waveform of a single frequency crosses the predetermined forward bias voltage after the first detection timing when the AC voltage output from the AC power source 11 is assumed to be the ideal AC voltage, the time being an end time of the detection stop period which is determined on the basis of the timing with the first detection timing as a reference, to a timing earlier than the first timing at which the ideal AC voltage crosses zero volts after the detection stop period ends. The control circuit 20 calculates a zero crossing point specifying parameter by halving a value which is obtained by subtracting the difference between the first detection timing and the second detection timing from a half cycle of the AC voltage using the first detection timing, the second detection timing, and a cycle of the AC voltage. The control circuit 20 specifies a zero crossing point (a zero crossing time) at which the AC voltage crosses zero volts on the basis of the zero crossing point specifying parameter and the cycle of the AC voltage. The control circuit 20 controls the switching operation of the switching element 16 on the basis of the specified zero crossing time.

Accordingly, even when the output of the AC power source 11 is in a high impedance state and even when the crossing point detecting unit 21 outputs the undesirable detection signal err, the zero crossing point detecting device 25 can accurately specify the zero crossing point of the AC voltage output from the AC power source 11.

The control circuit 20 sets one of timings as a new first detection timing which is used to specify the zero crossing time of a next cycle. The timings are a timing which is obtained by adding the half cycle of the AC voltage output from the AC power source 11 and double the zero crossing point specifying parameter to the second detection timing, a timing which is obtained by adding one cycle of the AC voltage output from the AC power source 11 to the first detection timing, and a timing at which the crossing point detecting unit 21 first detects the crossing of the AC voltage and the predetermined forward bias voltage when the AC voltage output from the AC power source 11 increases with the lapse of time after the specified zero crossing time. The control circuit 20 specifies a new second detection timing in the next cycle using the new first detection timing. The control circuit 20 calculates a new zero crossing point specifying parameter in the next cycle on the basis of the new first detection timing in the next cycle and the new second detection timing in the next cycle. The control circuit 20 specifies a new zero crossing time in the next cycle on the basis of the calculated new zero crossing point specifying parameter in the next cycle and the cycle of the AC voltage output from the AC power source 11. The control circuit 20 repeatedly performs the process of controlling the switching operation of the switching element 16 on the basis of the specified new zero crossing time in the next cycle.

Accordingly, even when the output of the AC power source 11 is in the high impedance state and even when the crossing point detecting unit 21 outputs the undesirable detection signal err, the zero crossing point detecting device 25 can accurately specify the zero crossing point of the AC voltage output from the AC power source 11 for each cycle.

In the zero crossing point detecting device 25, the control circuit 20 may generate the control signal for controlling the switching element 16 on the basis of the detection results of the load current detecting unit 22 and the load voltage detecting unit 23, for example, as described in Japanese Patent No. 5409152. A detailed description thereof will not be made.

Accordingly, the zero crossing point detecting device 25 can decrease a harmonic component included in a current supplied to the load 15, thereby improving a power factor.

By performing the processes of steps S4 and S11 of causing the control circuit 20 according to the embodiment of the present invention to determine whether the calculated difference (t2-t1) is within the range of theoretical values which are possible from the difference (t2-t1), it is possible to prevent the value of the zero crossing point specifying parameter zc from being an improper value when the first detection timing is erroneously detected due to a certain reason.

The process flow according to the embodiment of the present invention may be changed in order as long as appropriate processes are performed.

The crossing point detecting unit 21 according to the embodiment of the present invention is exemplified by a circuit operating with an application of a positive source voltage VCC as shown in FIG. 2, but the present invention is not limited to this example. The crossing point detecting unit 21 may be, for example, a circuit in which the bipolar transistor 205 is a PNP transistor and which operates with an application of a negative source voltage -VEE. In this case, the voltage Vth in FIGS. 3, 4, and 5 is a negative voltage. In the zero crossing point detecting device 25, the crossing point detecting unit 21 detects the crossing of the AC voltage output from the AC power source 11 and a predetermined negative voltage. The control circuit 20 specifies a first detection timing at which the crossing point detecting unit 21 first detects the crossing of the AC voltage and the predetermined forward bias voltage after the AC voltage decreases from a voltage which is equal to or higher than zero volts. The control circuit 20 specifies a second detection timing at which the crossing point detecting unit 21 finally detects the crossing of the AC voltage and the predetermined forward bias voltage when the AC voltage decreases with the lapse of time. The second detection timing is specified in the predetermined detection period from a time before the first timing at which the ideal AC voltage with a sinusoidal waveform of a single frequency crosses the predetermined forward bias voltage (the predetermined positive voltage) for causing the photo diode of the photo-coupler 201 to emit light after the first detection timing when the AC voltage output from the AC power source 11 is assumed to be the ideal AC voltage, the time being an end time of the detection stop period which is determined on the basis of the timing with the first detection timing as a reference, to a timing earlier than the first timing at which the ideal AC voltage crosses zero volts after the detection stop period ends. The control circuit 20 calculates a zero crossing point specifying parameter by halving a value which is obtained by subtracting the difference between the first detection timing and the second detection timing from a half cycle of the AC voltage using the first detection timing, the second detection timing, and the cycle of the AC voltage. The control circuit 20 specifies a zero crossing time at which the AC voltage crosses zero volts on the basis of the zero crossing point specifying parameter and the cycle of the AC voltage. The control circuit 20 controls the switching operation of the switching element 16 which is used to rectify an AC voltage into a DC voltage on the basis of the specified zero crossing time.

While embodiments of the present invention have been described, the above-mentioned zero crossing point detecting device 25 includes a computer system therein. The above-mentioned process flow is stored in the form of a program in a computer-readable recording medium, and the processes are performed by causing a computer to read and execute the program. Examples of the computer-readable recording medium include a magnetic disk, a magneto-optical disk, a compact disc read-only memory (CD-ROM), a digital versatile ROM (DVD-ROM), and a semiconductor memory. The computer program may be transmitted to a computer via a communication line and the computer having received the computer program may execute the computer program.

The program may embody a part of the above-mentioned functions. The program may be a file, that is, a differential file (a differential program), which can embody the above-mentioned functions by a combination with a program which is pre-recorded in the computer system.

While some embodiments of the present invention have been described, the embodiments are only examples and do not limit the scope of the invention. These embodiments may be subjected to various additions, omissions, substitutions, or modifications without departing from the gist of the invention.

## Claims

1. A zero crossing point detecting device (25) comprising:
a crossing point detecting unit (21) configured to detect a crossing of an alternating current voltage and a predetermined positive voltage (Vth); and
a control circuit (20) configured to specify a first detection timing (t1), the first detection timing being a timing at which the crossing point detecting unit (21) detects the crossing when the alternating current voltage is being increased,
wherein the zero crossing point detecting device is **characterized by** the control circuit (20) specifying a second detection timing (t2), the second detection timing being a timing at which the crossing point detecting unit (21) detects the crossing during a predetermined detection period, the predetermined detection period being a period from an end time of a detection stop period to a detection period end time, the end time of the detection stop period being determined on the basis of the first detection timing, the end time of the detection stop period being earlier than when the voltage initially crosses the predetermined positive voltage after the first detection timing with the alternating current voltage being assumed to be an ideal alternating current voltage having a sinusoidal waveform of a single frequency, the detection period end time being earlier than when the voltage initially crosses zero volts after end of the detection stop period,
the control circuit (20) subtracting a difference between the first detection timing and the second detection timing from a half cycle (Tp/2) of the alternating current voltage to obtain a value, the control circuit (20) halving the obtained value to calculate a zero crossing point specifying parameter (zc),
the control circuit (20) specifying a zero crossing time at which the alternating current voltage crosses zero volts on the basis of either one of the first or second detection timing, the zero crossing point specifying parameter and the cycle of the alternating current voltage, the control circuit controlling, on the basis of the specified zero crossing time, a switching operation of a switching element (16) which is used to rectify the alternating current voltage into a direct current voltage.

2. The zero crossing point detecting device (25) according to claim 1, wherein the control circuit (20) is configured to add one cycle of the alternating current voltage to the first detection timing and to decrease by the zero crossing point specifying parameter, or to add the half cycle of the alternating current voltage to the zero crossing point specifying parameter to specify the zero crossing time at the second detection timing.

3. The zero crossing point detecting device (25) according to claim 1 or 2, wherein the control circuit (20) is configured to repeatedly perform a process of setting one of a timing which is obtained by adding the half cycle of the alternating current voltage and double the zero crossing point specifying parameter to the second detection timing, a timing which is obtained by adding one cycle of the alternating current voltage to the first detection timing, and a timing at which the crossing point detecting unit first detects the crossing when the alternating current voltage is changed from a low voltage side to a high voltage side after the specified zero crossing time as a new first detection timing which is used to specify the zero crossing time of a next cycle, specifying a new second detection timing in the next cycle using the specified new first detection timing, calculating a new zero crossing point specifying parameter in the next cycle on the basis of the new first detection timing in the next cycle and the new second detection timing in the next cycle, specifying a new zero crossing time in the next cycle on the basis of the new zero crossing point specifying parameter in the next cycle and the cycle of the alternating current voltage, and controlling the switching operation of the switching element on the basis of the specified new zero crossing time in the next cycle.

4. A power supply device (10) comprising the zero-point detecting device of Claim 1, further comprising:
a rectifier circuit (13) configured to convert alternating current power output from an alternating current power source (11) into direct current power and to supply the direct current power to a load;
a reactor (12) that is connected in series between an output of the alternating current power source (11) and the rectifier circuit (13);
a switching element (16) that is connected in parallel to a path of an alternating current voltage which is applied to the rectifier circuit (13) via the reactor and performs a switching operation;
a smoothing circuit (14) that is connected in parallel to the rectifier circuit (13); a crossing point detecting unit (21) configured to detect a crossing of an alternating current voltage and a predetermined positive voltage, the predetermined positive voltage being output from an alternating current power source (11).

5. A zero crossing point detecting method comprising:
detecting a crossing of an alternating current voltage and a predetermined positive voltage, the predetermined positive voltage being output from an alternating current power source (11); and
specifying a first detection timing, the first detection timing being a timing at which a crossing point detecting unit detects the crossing when the alternating current voltage is being increased;
wherein the zero crossing point detecting method is **characterized by**
specifying a second detection timing, the second detection timing being a timing at which the crossing point detecting unit detects the crossing during a predetermined detection period, the predetermined detection period being a period from an end time of a detection stop period to an detection period end time, the end time of the detection stop period being determined on the basis of the first detection timing, the end time of the detection stop period being earlier than when the voltage initially crosses the predetermined positive voltage after the first detection timing with the alternating current voltage being assumed to be an ideal alternating current voltage having a sinusoidal waveform of a single frequency, the detection period end time being earlier than when the voltage initially crosses zero volts after end of the detection stop period;
subtracting a difference between the first detection timing and the second detection timing from a half cycle of the alternating current voltage to obtain a value;
halving the obtained value to calculate a zero crossing point specifying parameter; and
specifying a zero crossing time at which the alternating current voltage crosses zero volts on the basis of the zero crossing point specifying parameter and the cycle of the alternating current voltage, and controlling, on the basis of the specified zero crossing time, a switching operation of a switching element (16) which is used to rectify the alternating current voltage into a direct current voltage.

6. A program when executed on the control circuit (20) of the zero crossing point detecting device (25) according to claim 1, carrying out the method according to Claim 5.

## Patentansprüche

1. Nulldurchgangspunktdetektiervorrichtung (25), umfassend:
eine Kreuzungspunktdetektiereinheit (21), die dazu ausgebildet ist, eine Kreuzung einer Wechselspannung und einer vorgegebenen positiven Spannung (Vth) zu detektieren, und
eine Steuerschaltung (20), die dazu ausgebildet ist, einen ersten Detektierzeitpunkt (t1) zu spezifizieren, wobei der erste Detektierzeitpunkt ein Zeitpunkt ist, an dem die Kreuzungspunktdetektiereinheit (21) die Kreuzung detektiert, wenn die Wechselspannung erhöht wird,
wobei die Nulldurchgangspunktdetektiervorrichtung **dadurch gekennzeichnet ist, dass**
die Steuerschaltung (20) einen zweiten Detektierzeitpunkt (t2) spezifiziert, wobei der zweite Detektierzeitpunkt ein Zeitpunkt ist, an dem die Kreuzungspunktdetektiereinheit (21) die Kreuzung während eines vorgegebenen Detektierzeitraums detektiert, wobei der vorgegebene Detektierzeitraum ein Zeitraum von einer Endzeit eines Detektierstoppzeitraums zu einer Detektierzeitraumendzeit ist, wobei die Endzeit des Detektierstoppzeitraums basierend auf dem ersten Detektierzeitpunkt bestimmt wird, wobei die Endzeit des Detektierstoppzeitraums früher ist, als wann die Spannung nach dem ersten Detektierzeitpunkt zuerst die vorgegebene positive Spannung kreuzt, wobei die Wechselspannung als ideale Wechselspannung mit einer sinusförmigen Wellenform mit einer einzigen Frequenz angenommen wird, wobei die Detektierzeitraumendzeit früher ist, als wann die Spannung nach dem Ende des Detektierstoppzeitraums zuerst null Volt kreuzt,
die Steuerschaltung (20) eine Differenz zwischen dem ersten Detektierzeitpunkt und dem zweiten Detektierzeitpunkt von einem Halbzyklus (Tp/2) der Wechselspannung subtrahiert, um einen Wert zu erhalten, wobei die Steuerschaltung (20) den erhaltenen Wert halbiert, um einen nulldurchgangspunktspezifizierenden Parameter (zc) zu berechnen,
die Steuerschaltung (20) eine Nulldurchgangszeit, bei der die Wechselspannung null Volt kreuzt, basierend auf dem ersten oder dem zweiten Detektierzeitpunkt, dem nulldurchgangspunktspezifizierenden Parameter und dem Zyklus der Wechselspannung spezifiziert, wobei die Steuerschaltung basierend auf der spezifizierten Nulldurchgangszeit einen Schaltvorgang eines Schaltelements (16) steuert, das verwendet wird, um die Wechselspannung zu einer Gleichspannung gleichzurichten.

2. Nulldurchgangspunktdetektiervorrichtung (25) nach Anspruch 1, wobei die Steuerschaltung (20) dazu ausgebildet ist, einen Zyklus der Wechselspannung dem ersten Detektierzeitpunkt hinzuzuaddieren und um den nulldurchgangspunktspezifizierenden Parameter zu reduzieren oder den Halbzyklus der Wechselspannung zu dem nulldurchgangspunktspezifizierenden Parameter hinzuzuaddieren, um die Nulldurchgangszeit an dem zweiten Detektierzeitpunkt zu spezifizieren.

3. Nulldurchgangspunktdetektiervorrichtung (25) nach Anspruch 1 oder 2, wobei die Steuerschaltung (20) dazu ausgebildet ist, wiederholt einen Vorgang des Einstellens von einem aus der Gruppe umfassend einen Zeitpunkt, der durch Addieren des Halbzyklus der Wechselspannung und des Zweifachen des nulldurchgangspunktspezifizierenden Parameters zu dem zweiten Detektierzeitpunkt erhalten wird, einen Zeitpunkt, der durch Addieren eines Zyklus der Wechselspannung zu dem ersten Detektierzeitpunkt erhalten wird, und einen Zeitpunkt, an dem die Kreuzungspunktdetektiereinheit zuerst die Kreuzung detektiert, wenn die Wechselspannung nach der spezifizierten Nulldurchgangszeit von einer Niederspannungsseite zu einer Hochspannungsseite wechselt, als neuen Detektierzeitpunkt, der verwendet wird, um die Nulldurchgangszeit eines nächsten Zyklus zu spezifizieren, des Spezifizierens eines neuen zweiten Detektierzeitpunkts in dem nächsten Zyklus durch Verwendung des spezifizierten neuen ersten Detektierzeitpunkts, des Berechnens eines neuen nulldurchgangspunktspezifizierenden Parameters in dem nächsten Zyklus basierend auf dem neuen ersten Detektierzeitpunkt in dem nächsten Zyklus und dem neuen zweiten Detektierzeitpunkt in dem nächsten Zyklus, des Spezifizierens einer neuen Nulldurchgangszeit in dem nächsten Zyklus basierend auf dem neuen nulldurchgangspunktspezifizierenden Parameter in dem nächsten Zyklus und dem Zyklus der Wechselspannung und des Steuerns des Schaltvorgangs des Schaltelements basierend auf der spezifizierten neuen Nulldurchgangszeit in dem nächsten Zyklus durchzuführen.

4. Stromversorgungsvorrichtung (10), umfassend die Nullpunktdetektiervorrichtung nach Anspruch 1, ferner umfassend:
eine Gleichrichterschaltung (13), die dazu ausgebildet ist, Wechselstromausgangsleistung von einer Wechselstromquelle (11) in Gleichstromleistung umzuwandeln und die Gleichstromleistung einem Verbraucher zuzuführen,
einen Reaktor (12), der zwischen einem Ausgang der Wechselstromquelle (11) und der Gleichrichterschaltung (13) in Reihe geschaltet ist,
ein Schaltelement (16), das mit einem Weg einer Wechselspannung, die über den Reaktor an die Gleichrichterschaltung (13) angelegt wird, parallel geschaltet ist und einen Schaltvorgang ausführt,
eine Glättungsschaltung (14), die mit der Gleichrichterschaltung (13) parallel geschaltet ist,
eine Kreuzungspunktdetektiereinheit (21), die dazu ausgebildet ist, eine Kreuzung einer Wechselspannung und einer vorgegebenen positiven Spannung zu detektieren, wobei die vorgegebene positive Spannung von einer Wechselstromquelle (11) ausgegeben wird.

5. Nulldurchgangspunktdetektierverfahren, umfassend:
Detektieren einer Kreuzung einer Wechselspannung und einer vorgegebenen positiven Spannung, wobei die vorgegebene positive Spannung von einer Wechselstromquelle (11) abgegeben wird, und
Spezifizieren eines ersten Detektierzeitpunkts, wobei der erste Detektierzeitpunkt ein Zeitpunkt ist, an dem eine Kreuzungspunktdetektiereinheit die Kreuzung detektiert, wenn die Wechselspannung erhöht wird,
wobei das Nulldurchgangspunktdetektierverfahren **gekennzeichnet ist durch**
Spezifizieren eines zweiten Detektierzeitpunkts, wobei der zweite Detektierzeitpunkt ein Zeitpunkt ist, an dem die Kreuzungspunktdetektiereinheit die Kreuzung während eines vorgegebenen Detektierzeitraums detektiert, wobei der vorgegebene Detektierzeitraum ein Zeitraum von einer Endzeit eines Detektierstoppzeitraums zu einer Detektierzeitraumendzeit ist, wobei die Endzeit des Detektierstoppzeitraums basierend auf dem ersten Detektierzeitpunkt bestimmt wird, wobei die Endzeit des Detektierstoppzeitraums früher ist, als wann nach dem ersten Detektierzeitpunkt die Spannung zuerst die vorgegebene positive Spannung kreuzt, wobei die Wechselspannung als ideale Wechselspannung mit einer sinusförmigen Wellenform mit einer einzigen Frequenz angenommen wird, wobei die Detektierzeitraumendzeit früher ist, als wann nach dem Ende des Detektierstoppzeitraums die Spannung zuerst null Volt kreuzt,
Subtrahieren einer Differenz zwischen dem ersten Detektierzeitpunkt und dem zweiten Detektierzeitpunkt von einem Halbzyklus der Wechselspannung, um einen Wert zu erhalten,
Halbieren des erhaltenen Werts, um einen nulldurchgangspunktspezifizierenden Parameter zu berechnen, und
Spezifizieren einer Nulldurchgangszeit, bei der die Wechselspannung null Volt kreuzt, basierend auf dem nulldurchgangspunktspezifizierenden Parameter und dem Zyklus der Wechselspannung, und Steuern, basierend auf der spezifizierten Nulldurchgangszeit, eines Schaltvorgangs eines Schaltelements (16), das verwendet wird, um die Wechselspannung zu einer Gleichspannung gleichzurichten.

6. Programm, das, wenn es auf der Steuerschaltung (20) der Nulldurchgangspunktdetektiervorrichtung (25) nach Anspruch 1 ausgeführt wird, das Verfahren nach Anspruch 5 durchführt.

## Revendications

1. Dispositif de détection de point de passage par zéro (25) comportant :
une unité de détection de point de passage (21) configurée pour détecter un croisement d'une tension à courant alternatif et d'une tension positive prédéterminée (Vth) ; et
un circuit de commande (20) configuré pour spécifier une première temporisation de détection (t1), la première temporisation de détection étant une temporisation à laquelle l'unité de détection de point de passage (21) détecte le croisement quand la tension à courant alternatif est augmentée,
dans lequel le dispositif de détection de point de passage par zéro est **caractérisé par**
le circuit de commande (20) qui spécifie une deuxième temporisation de détection (t2), la deuxième temporisation de détection étant une temporisation à laquelle l'unité de détection de point de passage (21) détecte le croisement au cours d'une période de détection prédéterminée, la période de détection prédéterminée étant une période depuis un temps de fin d'une période d'arrêt de détection jusqu'à un temps de fin de période de détection, le temps de fin de la période d'arrêt de détection étant déterminé sur la base de la première temporisation de détection, le temps de fin de la période d'arrêt de détection étant plus tôt que quand la tension croise initialement la tension positive prédéterminée après la première temporisation de détection avec la tension à courant alternatif qui est supposée être une tension à courant alternatif idéale ayant une forme d'onde sinusoïdale d'une fréquence unique, le temps de fin de période de détection étant plus tôt que quand la tension croise initialement zéro volt après la fin de la période d'arrêt de détection,
le circuit de commande (20) soustrayant une différence entre la première temporisation de détection et la deuxième temporisation de détection d'un demi-cycle (Tp/2) de la tension à courant alternatif pour obtenir une valeur, le circuit de commande (20) divisant par deux la valeur obtenue pour calculer un paramètre spécifiant un point de passage par zéro (zc),
le circuit de commande (20) spécifiant un temps de passage par zéro où la tension à courant alternatif croise zéro volt sur la base d'un de la première ou deuxième temporisation de détection, du paramètre spécifiant un point de passage par zéro et du cycle de la tension à courant alternatif, le circuit de commande commandant, sur la base du temps de passage par zéro spécifié, une opération de commutation d'un élément de commutation (16) qui est utilisé pour redresser la tension à courant alternatif en une tension à courant continu.

2. Dispositif de détection de point de passage par zéro (25) selon la revendication 1, dans lequel le circuit de commande (20) est configuré pour ajouter un cycle de la tension à courant alternatif à la première temporisation de détection et pour diminuer du paramètre spécifiant un point de passage par zéro, ou pour ajouter le demi-cycle de la tension à courant alternatif au paramètre spécifiant un point de passage par zéro pour spécifier le temps de passage par zéro à la deuxième temporisation de détection.

3. Dispositif de détection de point de passage par zéro (25) selon la revendication 1 ou 2, dans lequel le circuit de commande (20) est configuré pour réaliser de manière répétée un processus d'établissement d'une d'une temporisation qui est obtenue en ajoutant le demi-cycle de la tension à courant alternatif et doubler le paramètre spécifiant un point de passage par zéro pour la deuxième temporisation de détection, d'une temporisation qui est obtenue en ajoutant un cycle de la tension à courant alternatif à la première temporisation de détection, et d'une temporisation à laquelle l'unité de détection de point de passage détecte en premier le croisement quand la tension à courant alternatif est changée d'un côté de basse tension à un côté de haute tension après le temps de passage par zéro spécifié comme nouvelle première temporisation de détection qui est utilisée pour spécifier le temps de passage par zéro d'un cycle suivant, en spécifiant une nouvelle deuxième temporisation de détection dans le cycle suivant en utilisant la nouvelle première temporisation de détection spécifiée, en calculant un nouveau paramètre spécifiant un point de passage par zéro dans le cycle suivant sur la base de la nouvelle première temporisation de détection dans le cycle suivant et de la nouvelle deuxième temporisation de détection dans le cycle suivant, en spécifiant un nouveau temps de passage par zéro dans le cycle suivant sur la base du nouveau paramètre spécifiant un point de passage par zéro dans le cycle suivant et le cycle de la tension à courant alternatif, et en commandant l'opération de commutation de l'élément de commutation sur la base du nouveau temps de passage par zéro spécifié dans le cycle suivant.

4. Dispositif d'alimentation (10) comportant le dispositif de détection de passage par zéro selon la revendication 1, comportant en outre :
un circuit redresseur (13) configuré pour convertir une sortie d'énergie à courant alternatif d'une alimentation à courant alternatif (11) en énergie à courant continu et pour délivrer l'énergie à courant continu à une charge ;
une réactance (12) qui est reliée en série entre une sortie de l'alimentation à courant alternatif (11) et le circuit redresseur (13) ;
un élément de commutation (16) qui est relié en parallèle à un passage d'une tension à courant alternatif qui est appliquée sur le circuit redresseur (13) par l'intermédiaire de la réactance et réalise une opération de commutation ;
un circuit de lissage (14) qui est relié en parallèle au circuit redresseur (13) ; une unité de détection de point de passage (21) configurée pour détecter un croisement d'une tension à courant alternatif et d'une tension positive prédéterminée, la tension positive prédéterminée étant délivrée par une alimentation à courant alternatif (11).

5. Procédé de détection de point de passage par zéro comportant le fait de :
détecter un croisement d'une tension à courant alternatif et d'une tension positive prédéterminée, la tension positive prédéterminée étant délivrée par une alimentation à courant alternatif (11) ; et
spécifier une première temporisation de détection, la première temporisation de détection étant une temporisation à laquelle une unité de détection de point de passage détecte le croisement quand la tension à courant alternatif est augmentée ;
selon lequel le procédé de détection de point de passage par zéro est **caractérisé par** le fait de
spécifier une deuxième temporisation de détection, la deuxième temporisation de détection étant une temporisation à laquelle l'unité de détection de point de passage détecte le croisement au cours d'une période de détection prédéterminée, la période de détection prédéterminée étant une période depuis un temps de fin d'une période d'arrêt de détection jusqu'à un temps de fin de période de détection, le temps de fin de la période d'arrêt de détection étant déterminée sur la base de la première temporisation de détection, le temps de fin de la période d'arrêt de détection étant plus tôt que quand la tension croise initialement la tension positive prédéterminée après la première temporisation de détection avec la tension à courant alternatif qui est supposée être une tension à courant alternatif idéale ayant une forme d'onde sinusoïdale d'une fréquence unique, le temps de fin de période de détection étant plus tôt que quand la tension croise initialement zéro volt après la fin de la période d'arrêt de détection ;
soustraire une différence entre la première temporisation de détection et la deuxième temporisation de détection d'un demi-cycle de la tension à courant alternatif pour obtenir une valeur ;
diviser par deux la valeur obtenue pour calculer un paramètre spécifiant un point de passage par zéro ; et
spécifier un temps de passage par zéro où la tension à courant alternatif croise zéro volt sur la base du paramètre spécifiant un point de passage par zéro et du cycle de la tension à courant alternatif, et commander, sur la base du temps de passage par zéro spécifié, une opération de commutation d'un élément de commutation (16) qui est utilisé pour redresser la tension à courant alternatif en une tension à courant continu.

6. Programme lorsqu'il est exécuté sur le circuit de commande (20) du dispositif de détection de point de passage par zéro (25) selon la revendication 1, mettant en oeuvre le procédé selon la revendication 5.
